# EUROPÄISCHE PATENTSCHRIFT

(11) **EP 0 467 108 B1**
(45) Veröffentlichungstag und Bekanntmachung des Hinweises auf die Patenterteilung: **20.11.1996**
(21) Anmeldenummer: 91110410.7
(22) Anmeldetag: 24.06.1991
(51) Int. Cl.: H03J 7/18

(54) **Fernsehsignal-Empfangsgerät mit einer einen Suchlauf enthaltenden Programmiereinrichtung**
Television receiving apparatus with a programming device provided with a sweep
Appareil récepteur de signal de télévision avec un dispositif de programmation à balayage

(30) Priorität: 19.07.1990 DE 4022921
(43) Veröffentlichungstag der Anmeldung: 22.01.1992
(73) Patentinhaber: Nokia (Deutschland) GmbH, D-75175 Pforzheim (DE)
(72) Erfinder: Apitz, Siegfried, Dipl.-Ing., W-7542 Schömberg-Bieselsberg (DE)

(56) Entgegenhaltungen:
- EP-A- 0 050 328
- EP-A- 0 115 009
- EP-A- 0 264 575
- DE-C- 3 145 407

## Beschreibung

Die Erfindung betrifft ein Fernsehsignal-Empfangsgerät mit einer einen Suchlauf enthaltenden Programmiereinrichtung nach dem Oberbegriff des Anspruches 1. Fernsehsignal-Empfangsgeräte sind insbesondere Fernsehgeräte und Videorecorder. Suchlaufeinrichtungen in derartigen Geräten dienen dazu, am Empfangsort empfangbare Sender automatisch zu suchen und deren Senderdaten, wie Frequenz und Programmquellencode, zu ermitteln und abzuspeichern und/oder anzuzeigen.

Für das Verständnis der Erfindung ist eine saubere Unterscheidung der Begriffe "Sender" und "Station" entscheidend. Im folgenden wird der Begriff "Sender" im Sinne eines Bauwerkes mit Antennenanlage zum Abstrahlen von Funksignalen und der "Station" für eine Institution benutzt, die Programme erstellt.

Wenn Fernsehsendungen ausgestrahlt werden, wird in vielen Fällen den Signalen ein Programmquellencode hinzugefügt. Werden beispielsweise Fernsehsendungen nach dem sogenannten VPS-Verfahren ausgestrahlt, ist der Programmquellencode jedesmal in der Datenzeile der übertragenen Fernsehbilder enthalten. Dieser Programmquellencode kennzeichnet die Station oder die Stationskette, die die Programmquelle der ausgestrahlten Sendung ist. Ist diese Station eine Einzelstation, bedeutet dies, daß diese Station gerade ein eigenes Programm sendet, das von keiner anderen Station übernommen wird. Ist diese Station dagegen eine Station einer Stationskette, bedeutet dies, daß mehrere Stationen ein gemeinsames Programm senden. Der Programmquellencode zeigt im letztgenannten Fall an, welche Stationen das Programm gerade gemeinsam senden, jedoch zeigt er nicht an, welche Station das Programm erstellt hat. Hier erscheint also die gesamte Stationskette als Programmquelle.

Bei einem aus der DE-Patentschrift 31 45 407 C2 bekannten Fernsehsignal-Empfangsgerät mit einer einen Suchlauf enthaltenden Programmiereinrichtung zum Belegen der über Stationstasten abrufbaren Stationsplätze der Einrichtung mit bestimmten, am Empfangsort empfangbaren Stationen werden in einer Senderdatentabelle für jeden empfangenen Sender die Empfangsfrequenz, der Programmquellencode und die Empfangsfeldstärke abgespeichert. Taucht ein bereits gefundener Programmquellencode für einen bei weitergeführtem Suchlauf gefundenen Sender erneut auf, wird ein Feldstärkevergleich durchgeführt. Weist der neugefundene Sender eine höhere Empfangsfeldstärke auf als der vorgefundene, werden für den zugehörigen Programmquellencode die Empfangsfrequenz und die Empfangsfeldstärke für den neuen Sender anstelle dieser Daten für den zuvor gefundenen Sender in die Sendertabelle eingeschrieben.

Wird dieser Suchlauf zu einer Zeit ausgeführt, zu der viele Einzelstationen zu einer Stationskette zusammengefaßt sind, senden alle zugehörigen Sender denselben Programmquellencode aus. Da für Sender mit demselben Programmquellencode nur die Daten für den stärksten Sender abgespeichert werden, werden die Daten zu den anderen empfangenen Sendern mit dem gleichen Programmquellencode unterdrückt. Möchte der Benutzer dann zu anderer Zeit Programme von Einzelstationen einstellen, muß er in diesem Fall die meisten Stationen von Hand suchen, da beim abgelaufenen Programmiervorgang die meisten Stationen unterdrückt wurden.

Um diesen Nachteil zu vermeiden, wird in der genannten deutschen Patentschrift vorgeschlagen nicht nur den Programmquellencode der Programmquelle der gerade übertragenen Sendung zu senden sondern auch eine Katalog von Programmquellencodes der Stationen und Stationsketten, von welchen der Sender überhaupt Programme sendet. Daten von einem Sender, der schwächer empfangen wird als ein anderer, werden in diesem Fall nur dann verworfen, wenn die Katalogdaten für die beiden Sender identisch sind. Von allen übrigen Sendern, deren Katalogdaten anzeigen, daß jeder der Sender außer dem gerade empfangenen gemeinsamen Programm zu anderen Zeiten Programme von einer Einzelstation sendet und daß sich die angegebenen Einzelstationen voneinander unterscheiden, werden beim automatischen Suchlauf die Daten für alle diese Sender, die gerade dasselbe Programm senden, abgespeichert.

Ein derartiger Programmquellenkatalog wird jedoch bis heute bei der Aussendung von Fernsehsendungen nicht übertragen. Andererseits wird, begünstigt durch die Kabelübertragung, die Zahl der empfangbaren Stationen und Stationsketten immer größer und in den erwerblichen Fernsehsignal-Empfangsgeräten eine immer größere Anzahl Stationsplätze angeboten, sodaß für den Benutzer eines derartigen Gerätes die Übersicht der Belegung der einzelnen Stationsplätze im Fernsehsignal-Empfangsgerät mit am Empfangsort empfangbaren Stationen immer unübersichtlicher wird.

Der Erfindung liegt die Aufgabe zugrunde, dem Benutzer die Stationswahl bei einem hohen Angebot an Stationsplätzen in dem zu bedienenden Fernsehsignal-Empfangsgerät und der hohen Anzahl empfangbarer Stationen dennoch übersichtlich zu machen.

Diese Aufgabe wird nach der Erfindung durch die im kennzeichnenden Teil des Anspruches 1 angegebenen Merkmale in vorteilhafter Art und Weise gelöst.

Das erfindungsgemäße Fernsehsignal-Empfangsgerät nutzt die Tatsache, daß jeder Sender eindeutig einer Einzelstation zugeordnet ist und jeder Sender irgendwann ein Programm nur von der ihm zugeordneten Einzelstation sendet, auch wenn diese Zuordnung häufig nicht sofort erkennbar ist, weil gerade ein Programm mit dem Programmquellencode einer Stationskette statt mit dem Programmquellencode einer Einzelstation gesendet wird. Die Programmiereinrichtung eines derartigen Fernsehsignal-Empfangsgerätes ist deshalb so ausgebildet, daß sie einen Suchlauf nicht nur einmalig ausführt, sondern wiederholt einen Suchlauf ausführt, solange, bis jedem Sender der Programmquellencode einer Einzelstation zugeordnet ist. In Sonderfällen kann diese Zuordnung bereits mit einem einzigen Suchlauf erzielt werden, wenn nämlich zufälligerweise gerade keinerlei Programm von einer Stationskette abgestrahlt wird, sondern aller Programme ausschließlich von Einzelstationen empfangen werden. Viel wahrscheinlicher ist jedoch der Fall, daß zu jedem Zeitpunkt, zu dem ein Suchlauf ausgeführt wird, mehrere Programme von Stationsketten und mehrere andere Programme von Einzelstationen empfangen werden. Um das Gerät nicht dauernd in Empfangsbetrieb zu halten, wird der Suchlauf jeweils nach einer bestimmten Wartezeit, beispielsweise einer halben Stunde, oder nach einem bestimmten Funktionsablauf, beispielsweise einem Aufnahme- oder einem Wiedergabebetrieb erneut startet. Da damit zu rechnen ist, daß nicht von jedem empfangbaren Sender ein Programmquellencode zu ermitteln ist, ist es von Vorteil den Programmiervorgang an eine Programmierendebedingung zu binden und das Programmierprogramm endgültig abzuschalten, wenn diese Programmierendebedingung eingetreten ist. Eine derartige Programmierendebedingung ist beispielsweise das Überschreiten einer bestimmten Anzahl von Suchläufen oder das Überschreiten einer bestimmten Einschaltdauer des Programmierprogrammes, beispielsweise das Überschreiten einer Wochenfrist, da weniger bedeutende Einzelstationen manchmal nur am Wochenende unter ihrem Programmquellencode senden.

Die Stationen, die ein Programm einer bestimmten Programmquelle über ihre Sender ausstrahlt, sind heute derart verkettet, daß dieses Programm nicht nur über die Sender von Einzelstationen sondern zusätzlich auch über die Sender der Stationen einer Stationskette ausgestrahlt werden. Bei der Ausstrahlung eines Programmes einer Programmquelle können somit Senderketten unterschiedlicher Rangordnung vorkommen. Es ist deshalb von Vorteil, in der in dem Fernsehsignal-Empfangsgerät enthaltenen Namenskürzeltabelle die den einzelnen Namenskürzeln zugeordneten Programmquellencodes so anzuordnen oder so zu kennzeichnen, daß daraus die Rangordnung der ihnen zugeordneten Programmquellen ermittelbar ist. Wenn vor der Auslösung eines Programmierprogrammes jedem Stationsplatz ein Programmquellencode einer Einzelstation zugeordnet ist, wird durch das ausgelöste Programmierprogramm der Programmiereinrichtung eines erfindungsgemäßen Fernsehsignal-Empfangsgerätes eindeutig festgelegt, welcher Sender zu einem jeweiligen Stationsplatz gehört oder welche Sender hierzu gehören. Werden mehrere Sender für einen Stationsplatz gefunden, werden die Daten für den stärksten Sender dem Stationsplatz zugewiesen.

In einer vorteilhaften Weiterbildung der Erfindung sind für die einzelnen Stationsplätze Stationstasten vorgesehen, durch deren wiederholtes Betätigen der Reihe nach auch die Senderdaten für die anderen empfangenen Sender mit gleichem Programmquellencode, aber einer geringeren Empfangsfeldstärke dem betreffenden Stationsplatz zugewiesen werden können. Es ist dann möglich, einen schwächer empfangenen Sender für eine bestimmte Station auszuwählen, was der Benutzer dann tun wird, wenn beispielsweise dem Bild vom stärker empfangenen Sender Störungen überlagert sind, die beim Bild vom schwächer empfangenen Sender fehlen.

Die Erfindung wird nachfolgend anhand vorteilhafter Ausführungsbeispiele näher erläutert. Diesen Beispielen sind weitere vorteilhafte Ausgestaltungen und Weiterbildungen der Erfindung zu entnehmen. In den zugehörigen Zeichnungen zeigen
- Fig. 1: ein schematisch dargestelltes Blockschaltbild der zur Senderprogrammierung erforderlichen Einrichtungen eines Fernsehsignal-Empfangsgerätes;
- Fig. 2: eine tabellarische Darstellung einer Namenskürzeltabelle der Programmiereinrichtung;
- Fig. 3: die tabellarische Darstellung einer Senderdatentabelle der Programmiereinrichtung;
- Fig. 4: ein Flußdiagramm des Programmablaufes der Programmiereinrichtung;
- Fig. 5: eine tabellarische Darstellung einer Stationsplatztabelle der Programmiereinrichtung;
- Fig. 6: ein Flußdiagramm des Programmablaufes zur Erstellung einer Stationsplatztabelle entsprechend Fig. 5;
- Fig. 7: ein Flußdiagramm zur Darstellung des Programmablaufes einer Stationsplatzauswahl.

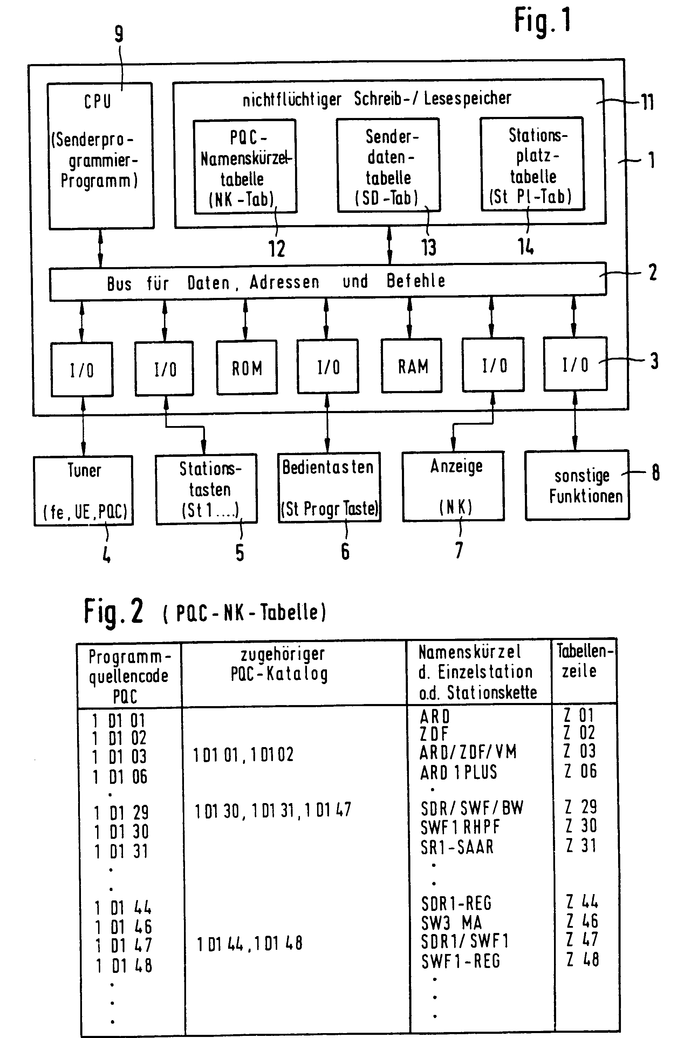

Die Figur 1 zeigt in einer schematischen Darstellung ein Blockschaltbild derjenigen Einrichtung eines Fernseh-Empfangsgerätes, die zur Senderprogrammierung eines Fernsehsignal-Empfangsgerätes notwendig sind. Die Schaltung besteht im wesentlichen aus einem Mikrocomputer 1 mit einem Bus 2 für Daten, Adressen und Steuerbefehle. Über diesen Bus werden mit Hilfe von Schnittstellen I/O, die mit der Bezugsziffer 3 gekennzeichnet sind, verschiedene Funktionsgruppen des Empfangsgerätes angesteuert, wie ein Tuner 4, ein Stationstastenfeld 5, ein Bedientastenfeld 6, eine Anzeigeanordnung 7 und sonstige Funktionsgruppen 8. Der Mikrocomputer 1 verfügt in üblicher Weise über eine Zentralprocessoreinheit (CPU) 9, die zusammen mit einem bestimmten Grundprogramm des Mikrocomputers die Funktion einer Senderprogrammiereinrichtung wahrnimmt. In einem nichtflüchtigen Schreib-/Lesespeicher 11 des Mikrocomputers 1 sind unter anderem in einem Namenskürzelspeicher 12 eine Namenskürzeltabelle (NK-Tab), in einem Senderdatenspeicher 13 eine Senderdatentabelle (SD-Tab) und in einem Stationsplatzspeicher 14 eine Stationsplatztabelle (StPl-Tab) gespeichert.

Im dargestellten Ausführungsbeispiel ist der Namenskürzelspeicher 12 ein Bestandteil des nichtflüchtigen Schreib-/Lesespeichers 11 des Mikrocomputers 1. Die im Namenskürzelspeicher gespeicherte, in Figur 2 dargestellte Namenskürzeltabelle (NK-Tab) ist beispielsweise von einem Händler, der für das Empfangsgebiet des Benutzers zuständig ist, in den nichtflüchtigen Speicher 11 eingespeichert worden, derart, daß sie vom Benutzer nicht ohne weiteres verändert werden kann. In anderen Ausführungsbeispielen ist die Namenskürzeltabelle in einem nur auslesbaren Speicher außerhalb des Mikrocomputers 1 in dem Fernsehsignal-Empfangsgerät installiert. Die in Figur 2 dargestellte Namenskürzeltabelle enthält auszugsweise in einer ersten Spalte die Programmquellencodes der einzelnen empfangbaren Einzelstationen und Stationsketten. Für jeden dieser Programmquellencodes ist eine Zeile vorgesehen, deren Zeilennummer in der vierten Spalte der Tabelle angegeben ist. Die dritte Spalte der Tabelle enthält die den Programmquellencodes der ersten Spalte zugeordneten Namenskürzel. Enthalten die Tabellenzeilen in der zweiten Spalte der Tabelle keinen Eintrag, sind die in der ersten Spalte der Tabelle angegebenen Programmquellencodes Einzelstationen zugeordnet. Im anderen Fall enthalten die Zeilen der Namenstabelle in der zweiten Spalte die Programmquellencodes der Einzelstationen oder Stationsketten, aus denen die dem Programmquellencode der ersten zugeordnete Stationskette gebildet ist. Durch diese Art der Aufstellung der Namenskürzeltabelle ist ohne weiteres ermittelbar, welche Programmcodes der ersten Spalte der Tabelle Einzelstationen zugeordnet sind.

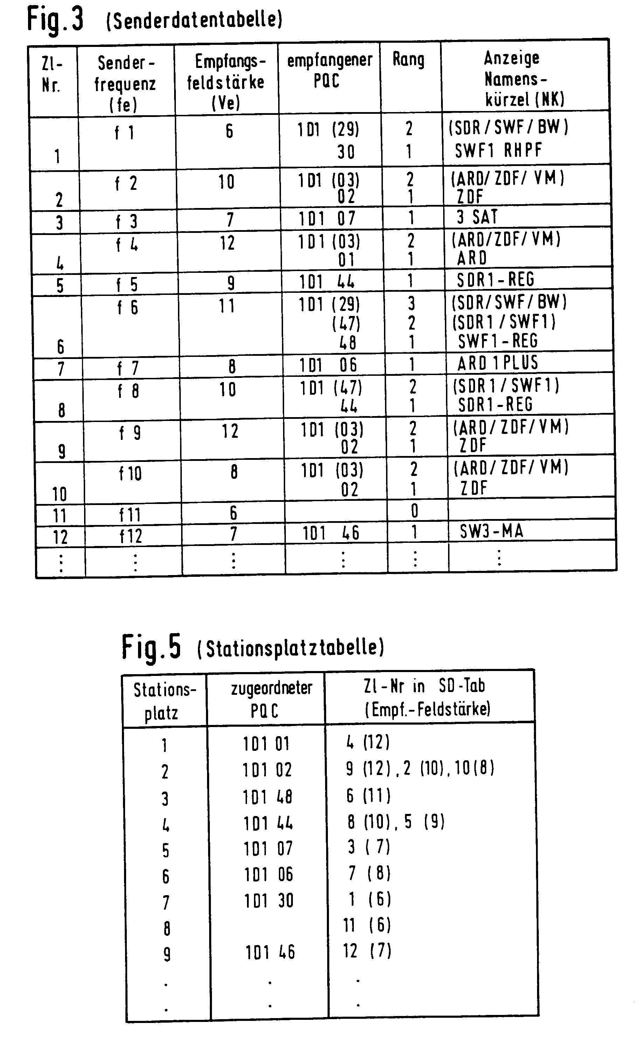

In Figur 3 sind die ersten zwölf Zeilen einer Senderdatentabelle (SD-Tab), die mittels eines Programmierprogrammes der Programmiereinrichtung 9 erstellt wird, schematisch dargestellt. Die erste Spalte dieser Tabelle enthält die Zeilennummer, die zweite und die dritte Spalte die Empfangsfrequenz fₑ und die Empfangsfeldstärke Uₑ der von dem Fernsehsignal-Empfangsgerät am Empfangsort empfangenen Sender. In der vierten Spalte der Senderdatentabelle ist der Programmquellencode (PQC) angegeben, der von dem Empfangsgerät aus dem Programm des empfangenen Senders ermittelt wurde. Die vorletzte und die letzte Spalte der Senderdatentabelle enthält den hierzu aus der Namenskürzeltabelle entnommenen Rang und das zugehörige Namenskürzel des ermittelten Programmquellencodes des empfangenen Senders.

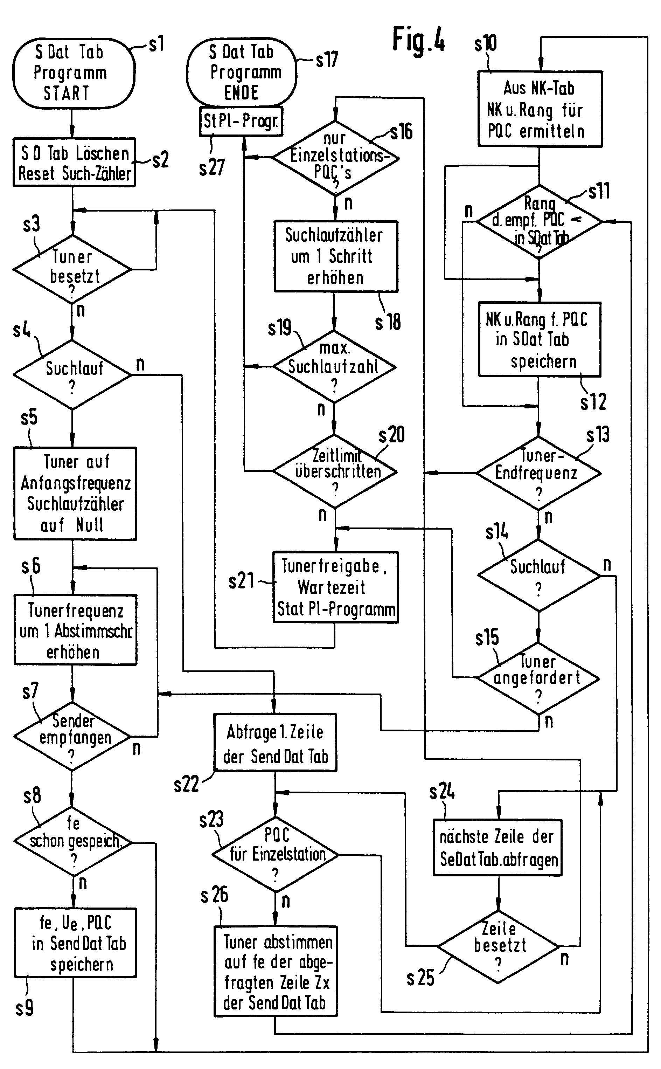

Eine im Senderdatenspeicher 13 des Fernsehsignal-Empfangsgerätes abgespeicherte, in Figur 3 schematisch dargestellte Senderdatentabelle SD-Tab wird mittels eines Programmierprogrammes, dessen Flußdiagramm in Figur 4 dargestellt ist, der Programmiereinrichtung 9 des Fernsehsignal-Empfangsgerätes hergestellt. Das Programmierprogramm wird durch ein nicht näher dargestelltes Betätigungselement des Bedientastenfeldes 6 des Empfangsgerätes gestartet. Durch diesen Start s1 wird das Programmierprogramm in einem Löschschritt s2 in einen Anfangszustand gesetzt, in dem sämtliche Speicherplätze der Senderdatentabelle gelöscht sind und ein Suchlaufzähler auf dem Zählschritt 1 gesetzt ist, mit dem er die Programmiereinrichtung in den Zustand des ersten Suchlaufes setzt (Schritt s4). Zuvor wird geprüft (Schritt s3), ob der Tuner 4 des Empfangsgerätes frei ist. Ist er von einer anderen Funktion des Empfangsgerätes belegt, wartet das Programmierprogramm solange, bis der Tuner frei ist und setzt danach die Abstimmfrequenz des Tuners auf den ersten Abstimmschritt (Programmschritt s6) nach der Anfangsfrequenz (Schritt s5) des Tuners. Im nächsten Programmschritt s7 wird geprüft, ob ein Sender mit ausreichender Empfangsfeldstärke empfangen wird und die Empfangsfrequenz solange schrittweise erhöht, bis ein Sender ausreichend stark empfangen wird. Von einem derartigen Sender werden im Programmschritt s9 die Abstimmfrequenz fₑ = f1, die Empfangsfeldstärke Uₑ = 6 und der mit der Sendung übertragene Programmquellencode PQC = 1D129 ermittelt und in die entsprechenden Spalten der ersten Zeile der Senderdatentabelle im Senderdatenspeicher eingespeichert. In den nächsten Programmschritten s10 bis s12 wird die Zeile 1 der Senderdatentabelle durch die zugehörigen Daten aus der Namenskürzeltabelle der Programmiereinrichtung 9 ergänzt und nach der Prüfung (Schritt s13), ob die Tunerendfrequenz erreicht ist, der Suchlauf mit dem Programmschritt s6 fortgesetzt. Auf diese Weise wird Zeile für Zeile der Senderdatentabelle erstellt, bis der Suchlauf die Endfrequenz des Tuners erreicht (Schritt s13) und mit diesem Schritt s13 den Suchlauf stoppt. In einem weiteren Programmschritt s16 ermittelt die Programmiereinrichtung 9, ob sämtliche aus den Programmen der empfangenen Sender ermittelten und gespeicherten Programmquellencodes einer Einzelstation zugeordnet sind. Ist dies der Fall, wird dadurch das Programmierprogramm beendet (Schritt s17). Die Programmiereinrichtung 9 ist damit ausgeschaltet. Andernfalls wird mit Programmschritt s21 das Programmierprogramm und damit die Programmiereinrichtung in einen Wartezustand gesetzt, in dem der Tuner für andere Funktionen freigegeben wird und außerdem das weiter unter beschriebenen Stationsplatzprogramm ausgelöst wird. In diesen Wartezustand wird das Programm auch am Ende eines Suchschrittes des Suchlaufes gesetzt, wenn der Tuner 4 während eines Suchlaufstoppes für eine andere Funktion, beispielsweise eine Empfangs- oder Wiedergabefunktion des Empfangsgerätes angefordert wird (Schritt s15).

Nach einer bestimmten Wartezeit wird ein neuer Suchlauf oder eine neue Abstimmfolge vom Programmschritt s21 ausgelöst, je nach Zählerstand des Suchlaufzählers. Bei der Auslösung einer Abstimmfolge wird der Tuner auf die Frequenz abgestimmt, die in der Spalte 2 der Senderdatentabelle abgelegt sind. Eine derartige Abstimmfolge ist im allgemeinen wesentlich kürzer als ein Suchlauf. Bei der Einstellung der Programmiereinrichtung auf den Lauf einer Abstimmfolge wird das Programmierprogramm über den Programmschritt s4 unmittelbar auf einen Programmschritt s22 zur Abfrage der ersten Zeile der Senderdatentabelle 13 eingestellt und geprüft, ob der in dieser Zeile gespeicherte Programmquellencode einer Einzelstation zugeordnet ist (Schritt s23). Ist dies der Fall, wird diese Prüfung über die Programmschritte s24 und s25 für die darauffolgenden Zeilen der Senderdatentabelle solange wiederholt, bis die letzte besetzte Zeile überschritten wird (Schritt s25) oder auf Programmschritt s23 eine Zeile der Senderdatentabelle ermittelt wird, in der der Programmquellencode einer Stationskette zugeordnet ist. Im ersten Fall wird der Lauf der Abstimmfolge wie ein Suchlauf mit Programmschritt s21 beendet, im andern Fall wird der Tuner in einem Programmschritt s26 auf die Senderfrequenz der negativ geprüften Senderdatentabelle abgestimmt und der von dem empfangenen Sender übertragene Programmquellencode ermittelt und in den darauffolgenden Programmschritten s10 und s11 mit der Namenskürzeltabelle verglichen. Ist der Rang des von dem empfangenen Sender übertragenen Programmquellencodes, zum Beispiel 1D1 30 kleiner als der Rang des in der Senderdatentabelle für diesen Sender enthaltenen Programmquellencodes 1D1 29, dann wird anstelle des in der Zeile für den Sender enthaltenen Programmquellencodes der erneut ermittelte Programmquellencode in die Senderdatentabelle eingespeichert und die Namenskürzeleinspeicherung dementsprechend richtiggestellt, wie in Figur 3 für die erste Zeile der Senderdatentabelle schematisch angedeutet ist. Die dort in Klammer gesetzten Anteile in der vierten und letzten Spalte sind in diesem Vorgang durch die darunter stehenden Daten ersetzt.

Ist der am Ende der Wartezeit des Programmschrittes s21 erneut gestartete Lauf ein Suchlauf, prüft das Programmierprogramm der Programmeinrichtung 9 auf Programmschritt s8 während des Suchlaufstoppes, ob die Sendefrequenz des empfangenen Senders bereits in der Senderdatentabelle enthalten ist. Ist die Sendefrequenz bereits in der Senderdatentabelle vorhanden, wird lediglich im Programmschritt s11 der Rang des übertragenen Programmquellencodes geprüft und notfalls im Programmschritt s12 in der Senderdatentabelle berichtigt. Andernfalls wird eine unbelegte Zeile der Senderdatentabelle zur Einspeicherung der ermittelten Senderdaten bereitgestellt. Eine derartige Zeile ist beispielsweise die Zeile 12 der in Figur 3 dargestellten Senderdatentabelle für eine Station, die beispielsweise nur am Wochenende als Einzelstation sendet.

Die Programmendebedingungen zum endgültigen Ausschalten des Programmierungsprogrammes und damit der Programmiereinrichtung 9 werden außer auf dem Programmschritt s16 noch mittels der Programmschritte s19 und s20 geprüft. Wird auf dem Programmschritt s16 keine Programmendebedingung festgestellt, wird im darauffolgenden Programmschritt s18 der Suchlaufzähler um einen Schritt erhöht und im Programmschritt s19 geprüft, ob der Suchlaufzähler die für eine Programmendebedingung festgelegte Zählerstellung erreicht hat. Wird das Programmierprogramm durch die Zählerstellung des Suchlaufzählers nicht beendet, wird auf dem Programmschritt s20 geprüft, ob die Einschaltdauer des Programmierprogrammzustandes des Fernsehsignal-Empfangsgerätes eine vorgegebene Zeit, beispielsweise eine Wochenfrist überschritten hat und in diesem Fall das Programmierprogramm ebenfalls beendet. Vor das Ende s17 des Programmierprogrammes ist nochmals ein Programmschritt s27 zum Start des weiter unten beschriebenen Stationsplatzprogrammes gesetzt.

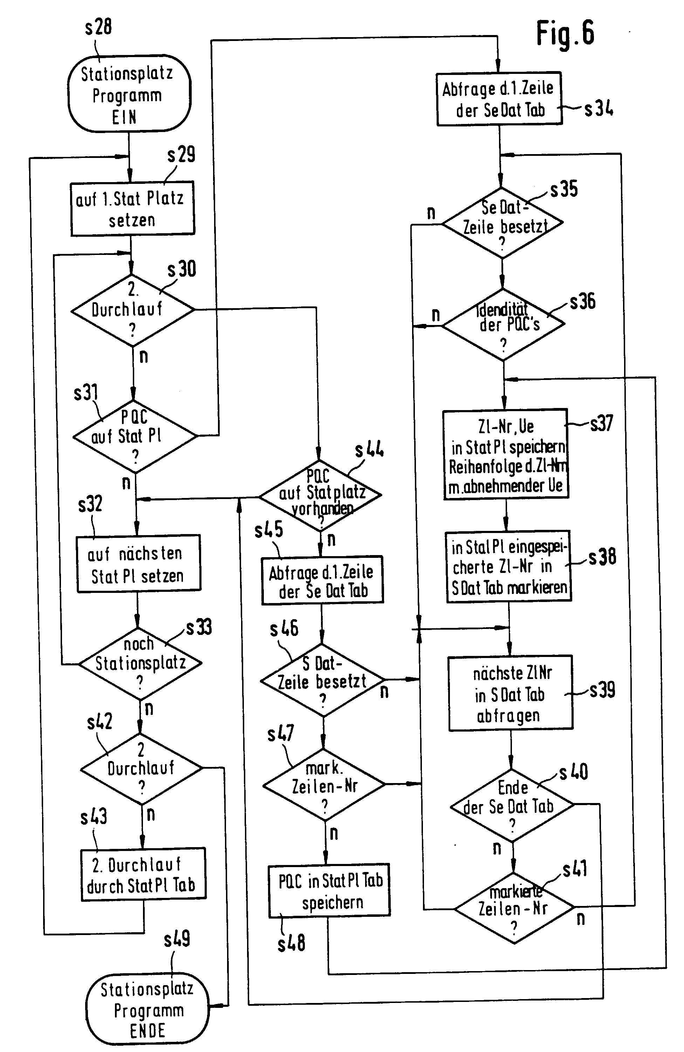

In Figur 5 ist ein Ausführungsbeispiel einer Stationsplatztabelle StPl-Tab dargestellt, die in einer ersten Spalte in aufsteigender Ziffernfolge die Nummern StPl 1, StPl 2, StPl 3 usw. der im nicht flüchtigen Schreib-/Lesespeicher 11 vorgesehenen Stationsplätze des Stationsspeichers 14 des Fernsehsignal-Empfangsgerätes enthält. Diesen Stationsplätzen ist jeweils eine bestimmte Einzelstation zugeordnet, deren Programmquellencode in der zweiten Spalte der Stationsplatztabelle angegeben ist. Diese Zuordnung wird beispielsweise nach Wahl des Benutzers von diesem selbst oder von einem Fachhändler durchgeführt. Die dritte Spalte der dargestellten Stationsplatztabelle enthält die Zeilennummer der in Figur 3 dargestellten Senderdatentabelle, in der ein Sender mit einem in der Speicherzeile des Stationsplatzes angegebenen Programmquellencodes identischen Programmquellencode einer Einzelstation enthalten ist. Außerdem sind in der dritten Spalte der Stationsplatztabelle in Klammer die der dort angegebenen Zeilennummer der Senderdatentabelle zugehörigen Empfangsfeldstärken angegeben. Für den Stationsplatz 2 sind beispielsweise in der dritten Spalte der Stationsplatztabelle drei Sender mit dem gleichen Programmquellencode für eine Einzelstation in der Reihenfolge abnehmender Empfangsfeldstärke aufgezeichnet. Die dritte Spalte der Stationsplatztabelle wird mittels eines Stationsplatzprogrammes der Programmiereinrichtung 9 erstellt, das nachfolgend anhand eines in Figur 6 dargestellten Flußdiagrammes erläutert wird.

Im dargestellten Ausführungsbeispiel wird das Stationsplatzprogramm der Programmiereinrichtung 9 des Fernsehsignal-Empfangsgerätes mit dem Programmschritt s21 während der Wartezeit des Programmierprogrammes oder mit dem Programmschritt s27 unmittelbar vor dem Endeschritt s17 zum Ausschalten des Programmierprogrammes gestartet (Programmstart s28). Im darauffolgenden Programmschritt s29 wird die Speicherzeile des ersten Stationsplatzes StPl 1 auf einen dort gespeicherten Programmquellencode abgefragt (Schritt s31). Wird kein Programmquellencode auf diesem Platz festgestellt, werden die einzelnen Stationsplätze nacheinander über die Programmschritte s30 bis s33 solange abgefragt, bis auf einem Stationsplatz ein Programmquellencode festgestellt wird. In diesem Fall prüft das Stationsplatzprogramm auf den Programmschritten s34 bis s36, ob die erste Zeile der Senderdatentabelle einen Programmquellencode enthält, der mit dem Programmquellencode des Stationsplatzes, auf dem das Stationsplatzprogramm gerade steht, beispielsweise auf dem Stationsplatz StPl 1, identisch ist. Besteht keine Identität prüft das Stationsplatzprogramm in den Schritten s39 bis s41 und den Programmschritten s34 bis s36 Zeile für Zeile der Senderdatentabelle auf einen identischen Programmquellencode, bis es eine Zeile der Senderdatentabelle findet, beispielsweise die Zeile 4, die einen identischen Programmquellencode enthält. Bei der Feststellung einer Identität wird in einem Programmschritt s37 die Zeilennummer und die Empfangsfeldstärke Uₑ in die dritte Spalte des Stationsplatzes 1 der Stationsplatztabelle gespeichert. Außerdem erhält die Zeilennummer, die gerade in der Stationsplatztabelle gespeichert wurde, in der Senderdatentabelle eine Markierung. Werden in weiteren in dieser Datenschleife s35 bis s41 überprüften Senderzeilen der Senderdatentabelle mit dem Programmquellencode des angewählten Stationsplatzes übereinstimmende Programmquellencode ermittelt, werden die Senderdaten auch dieser Senderdatenzeilen in die dritte Spalte der Stationsplatztabelle eingespeichert, und zwar in der Reihenfolge abnehmender Empfangsfeldstärke, wie dies in Figur 5 für den zweiten Stationsplatz der Stationsplatztabelle in der dritten Spalte mit den ermittelten Senderdatenzeilen 9, 2 und 10 schematisch dargestellt ist.

Wird beim weiteren Absuchen oder überhaupt beim Absuchen der Senderdatentabelle keine Identität eines in der Senderdatentabelle gespeicherten Programmquellencodes mit dem Programmquellencode des Stationsplatzes festgestellt, auf dem das Stationsplatzprogramm gerade steht, d. h. erreicht das Programm das Ende der Senderdatentabelle (Schritt s40), wird das Stationsplatzprogramm wieder auf die Abfrageschleife s32 bis s31 zur Abfrage der nächsten Stationsplätze gesetzt. Erreicht bei dieser Abfrage das Stationsplatzprogramm auf Schritt s33 das Ende der Stationsplatztabelle, schaltet das Stationsplatzprogramm sich auf einem Schritt s43 auf einen zweiten Durchlauf durch die Stationsplatztabelle, indem über Schritt s44 Stationsplätze gesucht werden, die nicht durch einen Programmquellencode besetzt sind. Das sind im dargestellten Ausführungsbeispiel die Stationsplätze 7, 8 und 9 der in Figur 5 dargestellten Stationsplatztabelle. Diese Stationsplätze werden der Reihe nach über die Programmschritte s45 bis s48 und s37 mit den entsprechenden Senderdaten der noch nicht markierten Zeilen der Senderdatentabelle belegt, so daß diese Stationsplätze mit Sendern in der Reihenfolge der Senderdatentabelle (Fig. 3) belegt sind. Nach dem zweiten Durchlauf des Stationsplatzprogrammes durch die Stationsplatztabelle wird das Stationsplatzprogramm über Schritt s42 und s49 beendet und die Markierungen der Zeilennummern der Senderdatentabelle gelöscht.

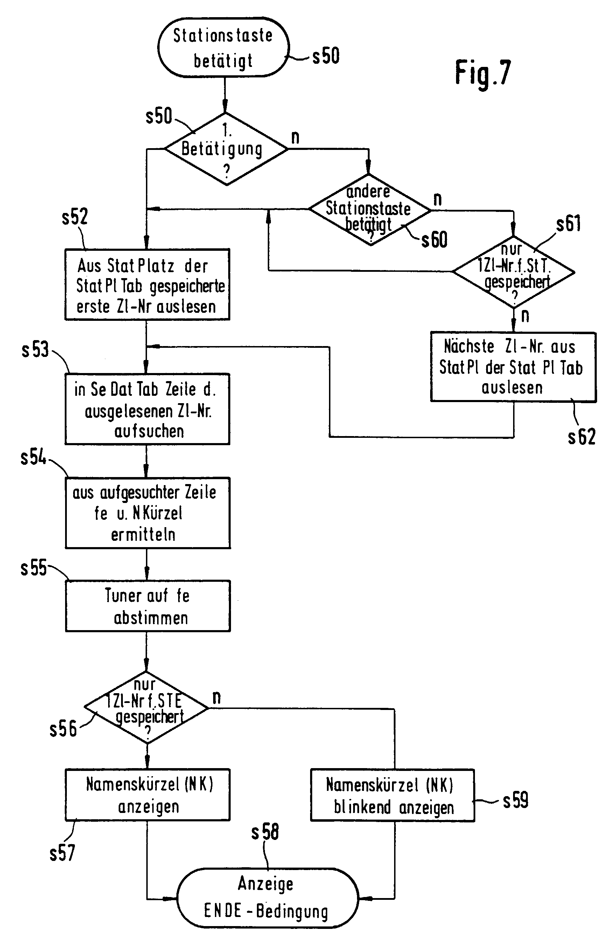

Mit der so vom Stationsplatzprogramm erstellten Stationsplatztabelle (Fig. 5) erhält das Fernsehsignal-Empfangsgerät in Verbindung mit der zuvor erstellten Senderdatentabelle (Fig. 3) eine Anordnung, mittels der das Fernsehsignal-Empfangsgerät automatisch auf eine gewünschte Station abgestimmt werden kann. Im dargestellten Ausführungsbeispiel enthält das Fernsehsignal-Empfangsgerät ein Stationstastenfeld 5 zur Auswahl eines bestimmten Stationsplatzes aus der Stationsplatztabelle mit den entsprechenden Zeilennummern der Senderdatentabelle, in denen die zur Abstimmung und Anzeige erforderlichen Daten enthalten sind. In Figur 7 ist schematisch ein Flußdiagramm für eine derartige Abstimmung auf eine bestimmte Station dargestellt. Bei einer erstmaligen Betätigung einer Stationstaste (Schritte s50 und s51) zur Auswahl einer bestimmten Station wird auf den Programmschritten s52 bis s55 des Abstimmprogrammes die auf dem angewählten Stationsplatz, beispielsweise Stationsplatz 2, die dort gespeicherte an erster Stelle der Spalte drei gespeicherte Zeilennummer der Senderdatentabelle ausgelesen, diese Zeilennummer in der Senderdatentabelle aufgesucht, der Tuner 4 des Fernsehsignal-Empfangsgerätes auf die aus dieser Senderdatenzeile ermittelte Frequenz abgestimmt und die Station mit dem aus dem Namenskürzel der aufgesuchten Senderdatenzeile angezeigt. Damit ist das Abstimmprogramm beendet (Schritt s58). Enthält die dritte Spalte des Stationsplatzes in der Stationsplatztabelle mehrere Zeilennummern, wie beispielsweise für die Stationsplätze 2 und 4, wird im dargestellten Ausführungsbeispiel das Namenskürzel blinkend angezeigt (Schritt s59). Auf diese Weise wird angezeigt, daß noch weitere Sender der Station empfangen werden können. Der Benutzer kann in diesem Fall durch ein erneutes Anwählen der gleichen Station das Fernsehsignal-Empfangsgerät auf einen anderen Sender der gleichen Station abstimmen und so gegebenenfalls auf den nächsten Sender ausweichen, wenn beispielsweise der Empfang des zuerst eingestellten Senders gestört sein sollte. In diesem Fall wählt das Abstimmprogramm über die Schritte s60 bis s62 die nächste Zeilennummer aus dem Stationsplatz der Stationsplatztabelle aus (Schritt s62) und stimmt den Tuner auf die aus dieser Zeile ausgelesene Frequens fₑ ab (Schritt s55).

Die Anzeige des Sendernamenkürzels kann entweder auf einem gesonderten Anzeigedisplay des Fernsehsignal-Empfangsgerätes oder insbesondere dann, wenn das Fernsehsignal-Empfangsgerät ein Fernseher ist, auf dem Bildschirm des Fernsehgerätes erfolgen.

## Patentansprüche

1. Fernsehsignal-Empfangsgerät
- mit einer einen Suchlauf enthaltenden Programmiereinrichtung zum Suchen am Empfangsort empfangbarer Sender und zum automatischen Erstellen einer abgespeicherten Senderdatentabelle, die für jeden empfangenen Sender die Abstimmdaten und einen Programmquellencode der Programmquelle des Senders enthält,
- und mit einem Stationsplatzspeicher, in dem jedem der empfangenen Sender ein Stationsplatz zugeordnet ist,
**gekennzeichnet,**
- durch eine abgespeicherte, elektronisch aus lesbare Namenskürzeltabelle (NK-Tab), die Programmquellencodes enthält und in der jedem Programmquellencode (PQC) ein Namenskürzel (NK) und ein Unterscheidungsmerkmal zugeordnet ist, ob die Zuordnung eine Einzelstation oder eine Stationskette betrifft,
- und mit einem Programmierprogramm (Fig. 4) der Programmiereinrichtung (9), das in einem Programmablauf wiederholt, nach einer bestimmten Wartezeit einen Suchlauf oder einen Abstimmlauf zur Ermittlung eines Programmquellencodes der in dem Lauf empfangenen Sender startet, der mit dem Programmquellencode einer in der Namenskürzeltabelle dem Programmquellencode zugeordneten Einzelstation identisch ist.

2. Fernsehsignal-Empfangsgerät nach Anspruch 1,
**gekennzeichnet**
durch eine Programmendebedingung (s16, s19, s20) zum Abschalten des Programmierprogrammes der Programmiereinrichtung (9), die der Zeitpunkt des Überschreitens einer bestimmten Einschaltdauer des Programmierzustandes der Programmiereinrichtung oder einer bestimmten Anzahl von Such- und Abstimmläufen der Programmiereinrichtung oder des Erreichens des Zustandes der Senderdatentabelle ist, in dem sämtliche gespeicherte Programmquellencodes einer Einzelstation zugeordnet sind.

3. Fernsehsignal-Empfangsgerät nach Anspruch 1 oder 2,
**dadurch gekennzeichnet,**
- daß die Namenskürzeltabelle Programmquellencodes von in Stationsketten höherer Rangordnung enthaltener Stationsketten enthält und
- daß das Programmierprogramm der Programmiereinrichtung (9) so ausgebildet ist, daß bei der Ermittlung eines Programmquellencodes eines in einem erneuten Such- oder Abstimmlauf empfangenen und in der Senderdatentabelle enthaltenen Senders der für diesen Sender in der Senderdatentabelle gespeicherte Programmquellencode durch den beim erneuten Lauf ermittelten Programmquellencode ersetzt wird, wenn der in der Sendertabelle bisher enthaltene Programmquellencode einer höherrangigen Stationskette zugeordnet ist als der im erneuten Lauf ermittelte Programmquellencode.

4. Fernsehsignal-Empfangsgerät nach einem der Ansprüche 1 bis 3,
**gekennzeichnet**
durch einen Programmschritt (s2) am Beginn des Programmierprogramms der Programmiereinrichtung (9), durch den eine in einem nichtflüchtigen Schreib-/Lesespeicher (11) enthaltene Senderdatentabelle (SD-Tab) gelöscht wird.

5. Fernsehsignal-Empfangsgerät nach einem der Ansprüche 1 bis 4,
**dadurch gekennzeichnet,**
daß der Abstimmlauf des Programmierprogrammes (Figur 4) der Programmiereinrichtung (9) eine Abstimmfolge auf die Sender ist, deren Senderdaten in der Senderdatentabelle enthalten sind und für die in der Senderdatentabelle ein Programmquellencode gespeichert ist, der nicht einer Einzelstation zugeordnet ist.

6. Fernsehsignal-Empfangsgerät nach einem der Ansprüche 1 bis 5,
**dadurch gekennzeichnet,**
daß der Programmablauf des Programmierprogrammes in der Programmiereinrichtung (9)so ausgebildet ist, daß den Stationsplätzen (StPl) der Stationsplatztabelle (StPl-Tab) nur der Sender einer Station zugeordnet ist, der entsprechend den in der Senderdatentabelle (SD-Tab) gespeicherten Senderdaten mit der größten Empfangsfeldstärke empfangen wurde.

7. Fernsehsignal-Empfangsgerät nach einem der Ansprüche 1 bis 5,
**dadurch gekennzeichnet,**
- daß der Programmablauf des Programmierprogrammes (Fig. 4) der Programmiereinrichtung (9) so ausgebildet ist, daß beim Empfang mehrerer einer Einzelstation zugehöriger Sender in der Stationsplatztabelle (14) die einem Stationsplatz zugehörigen Sender einer Einzelstation in der Reihenfolge abnehmender Empfangsfeldstärke gespeichert sind,
- und daß ein wiederholtes Betätigen der einem Stationsplatz zugeordneten Betätigungselemente (5) der Tuner (4) des Empfangsgerätes der Reihe nach auf die dem Stationsplatz zugeordneten Sender abgestimmt wird.

## Claims

1. A television signal receiver
- with a programming device containing a search run for searching at the reception location of receivable transmitters and for automatically creating a stored transmitter data table which for each received transmitter contains the tuning data and a program source code of the program source of the transmitter,
- and with a station position store in which each of the received transmitters is assigned a station position,
characterised by
- a stored, electronically readable name abbreviation table (NK-Tab) which contains program source codes and in which each program source code (PQC) is assigned a name abbreviation (NK) and a distinguishing feature relating to whether the assignment relates to an individual station or a station chain,
- and with a programming program (Fig. 4) of the programming device (9) which in a program run repeatedly, after a specified waiting time, starts a search run or a tuning run for determining a program source code of the transmitters received in the run, which program source code is identical to the program source code of an individual station assigned to the program source code in the name abbreviation table.

2. A television signal receiver as claimed in Claim 1, characterised by a program end condition (s16, s19, s20) for switching off the programming program of the programming device (9), which condition is the time of the overshooting of a specified switch-on duration of the programming state of the programming device or of a specified number of search- and tuning runs of the programming device or the attainment of that state of the transmitter data table in which all the stored program source codes are assigned to an individual station.

3. A television signal receiver as claimed in Claim 1 or 2, characterised in that
- the name abbreviation table contains program source codes of station chains contained in station chains of a higher priority and
- the programming program of the programming device (9) is designed such that in the case of the determination of a program source code of a transmitter received in a repeated search- or tuning run and contained in the transmitter data table, the program source code stored for this transmitter in the transmitter data table is replaced by the program source code determined in the repeated run when the program source code previously contained in the transmitter table is assigned to a station chain of a higher priority than the program source code determined in the repeated run.

4. A television signal receiver as claimed in one of Claims 1 to 3, characterised by a program step (s2) at the start of the programming program of the programming device (9), by which step a transmitter data table (SD-Tab) contained in a non-volatile write-read memory (11) is erased.

5. A television signal receiver as claimed in one of Claims 1 to 4, characterised in that the tuning run of the programming program (Figure 4) of the programming device (9) is a tuning sequence relating to those transmitters whose transmitter data are contained in the transmitter data table and for which a program source code not assigned to an individual station is stored in the transmitter data table.

6. A television signal receiver as claimed in one of Claims 1 to 5, characterised in that the program run of the programming program in the programming device (9) is designed such that the station positions (StPl) of the station position table (StPl-Tab) are assigned only that transmitter of a station which has been received, in accordance with the transmitter data stored in the transmitter data table (SD-Tab) with the greatest receiving field strength.

7. A television signal receiver as claimed in one of Claims 1 to 5, characterised in that
- the program run of the programming program (Fig. 4) of the programming device (9) is designed such that in the event of the reception of a plurality of transmitters assigned to an individual station, in the station position table (14) those transmitters of an individual station which are assigned to a station position are stored in the sequence of decreasing receiving field strength
- and in that by repeated actuation of the actuating elements (5) assigned to a station position, the tuner (4) of the receiver is tuned in turn to the transmitters assigned to the station position.

## Revendications

1. Récepteur de signaux de télévision
- avec un dispositif de programmation comportant une fonction de recherche pour rechercher des émetteurs pouvant être captés sur le lieu de réception et pour établir automatiquement un tableau de données d'émetteur mémorisé qui contient pour chaque émetteur capté les données de réglage et un code de source de programme de l'émetteur,
- et avec une mémoire à emplacements de stations dans laquelle un emplacement de station est associé à chacun des émetteurs captés,
caractérisé
- par un tableau de sigles (NK-Tab) mémorisé et pouvant être lu électroniquement, qui contient des codes de source de programmes et dans lequel il est associé à chaque code de source de programme (PQC) un sigle (NK) et un caractère distinctif permettant de déterminer si l'association porte sur une station individuelle ou sur une chaîne de stations,
- et avec un programme de programmation (figure 4) du dispositif de programmation (9) qui, de façon répétée au cours d'une exécution de programme, lance après un temps d'attente déterminé, une séquence de recherche ou une séquence de réglage pour déterminer un code de source de programme des émetteurs captés pendant la séquence, lequel code est identique au code de source de programme d'une station individuelle associée au code de source de programme dans le tableau de sigles.

2. Récepteur de signaux de télévision selon la revendication 1,
caractérisé
par une condition de fin de programme (s16, s19, s20) destinée à arrêter le programme de programmation du dispositif de programmation (9), laquelle condition est le moment du dépassement d'une durée déterminée d'enclenchement de l'état de programmation du dispositif de programmation ou d'un nombre déterminé de séquences de recherche ou de réglage du dispositif de programmation, ou le moment où dans le tableau de données d'émetteurs on atteint l'état dans lequel tous les codes de source de programmes mémorisés sont associés à une station individuelle.

3. Récepteur de signaux de télévision selon la revendication 1 ou 2,
caractérisé en ce
- que le tableau de sigles contient des codes de source de programmes de chaînes de stations comprises dans des chaînes de stations de rang plus élevé et
- que le programme de programmation du dispositif de programmation (9) est réalisé de telle manière que lors de la détermination d'un code de source de programme d'un émetteur capté au cours d'une nouvelle séquence de recherche ou de réglage et contenu dans le tableau de données d'émetteurs, le code de source de programme mémorisé pour cet émetteur dans le tableau de données d'émetteur est remplacé par le code de source de programme déterminé lors de la nouvelle séquence lorsque le code de source de programme contenu jusque là dans le tableau d'émetteurs est associé à une chaîne de stations de rang plus élevé que le code de source de programme déterminé au cours de la nouvelle séquence.

4. Récepteur de signaux de télévision selon l'une des revendications 1 à 3,
caractérisé
par une étape de programme (s2) au début du programme de programmation du dispositif de programmation (9), par laquelle un tableau de données d'émetteurs (SD-Tab) contenu dans une mémoire à écriture-lecture non volatile (11) est effacé.

5. Récepteur de signaux de télévision selon l'une des revendications 1 à 4,
caractérisé en ce
que la séquence de réglage du programme de programmation (figure 4) du dispositif de programmation (9) est une séquence de réglage sur les émetteurs dont les données d'émetteur sont contenues dans le tableau de données d'émetteurs et pour lesquels il est mémorisé dans le tableau de données d'émetteurs un code de source de programme qui n'est pas associé à une station individuelle.

6. Récepteur de signaux de télévision selon l'une des revendications 1 à 5,
caractérisé en ce
que le déroulement du programme de programmation dans le dispositif de programmation (9) est réalisé de telle manière qu'il est associé aux emplacements de stations (StP1) du tableau d'emplacements de stations (StP1-Tab), uniquement l'émetteur d'une station qui a été capté avec la plus grande intensité de champ de réception conformément aux données d'émetteurs mémorisées dans le tableau de données d'émetteurs (SD-Tab).

7. Récepteur de signaux de télévision selon l'une des revendications 1 à 5,
caractérisé en ce
- que le déroulement du programme de programmation (figure 4) du dispositif de programmation (9) est réalisé de telle manière que lors de la réception de plusieurs émetteurs appartenant à une station individuelle, on mémorise dans le tableau d'emplacements de stations (14), les émetteurs d'une station individuelle associés à un emplacement de station par ordre décroissant d'intensité de champ de réception,
- et que en actionnant de manière répétée les éléments de commande (5) associés à un emplacement de station, on règle le tuner (4) du récepteur à tour de rôle sur les émetteurs associés à l'emplacement de station.
